# EUROPEAN PATENT APPLICATION

(11) **EP 1 780 800 A2**
(43) Date of publication of application: **02.05.2007**
(21) Application number: 06022742.8
(22) Date of filing: 31.10.2006
(51) Int. Cl.: H01L 31/0272, H01L 31/0328, H01L 31/08, H01L 31/18

(54) **Photoconductive layer forming radiation image taking panel and radiation image taking panel**

(30) Priority: 01.11.2005 JP 2005318839; 01.11.2005 JP 2005318840
(71) Applicant: Fujifilm Corporation, Minato-ku Tokyo (JP)
(72) Inventor: Miyake, Kiyoteru, Ashigarakami-gun, Kanagawa-ken (JP)
(74) Representative: Klunker . Schmitt-Nilson . Hirsch

(57) **Abstract**

A photoconductive layer (2) for a radiation image taking panel (10) is formed by selenium alloy containing 0.1 to 1000 molar ppm of monovalent metal and 0.1 to 1000 molar ppm of a chalcogenide element other than Se or selenium alloy containing 0.1 to 1000 molar ppm of monovalent metal and 0.1 to 100 molar ppm of a V group element.

## Description

### BACKGROUND OF THE INVENTION

### Field of the Invention

This invention relates to a radiation image taking panel suitable for a radiograph system such as x-ray system, and more particularly to a photoconductive layer forming a radiation image taking panel.

### Description of the Related Art

There has been known an x-ray image taking panel in which a photoconductive layer sensitive to x-rays is employed as a photosensitive body and an electrostatic latent image formed on the photoconductive layer by the x-rays is read and recorded by light or a number of electrodes in order to reduce the dose of radiation to which the examinee is exposed in the medical x-raying. This procedure is excellent as compared with a conventional indirect shooting by the use of a TV pickup tube in that it is high in resolution.

The x-ray image taking panel, in response to projection of x-rays onto an electric charge generating layer provided therein, generates an electric charge corresponding to the energy of the x-rays and reads out the generated electric charge as an electric signal, whereby the photoconductive layer functions as an electric charge generating layer. Conventionally, amorphous selenium (a-Se), PbO, PbI₂, HgI₂, BiI₃, Cd (ZN) Te and the like have been used as material of the photoconductive layer.

Though the amorphous selenium is easily made in a large area by a film forming technic such as vacuum deposition, the amorphous selenium tends to include a lot of structural drawbacks inherent to the amorphous and is apt to deteriorate in its sensitivity. Accordingly, doping of impurities has been in wide use, and, for instance, in U.S. Patent Application Publication No. 20030223534, there is disclosed a photoconductive layer using the amorphous selenium doped with alkaline metal.

Further, there has been known an addition of a chalcogenide element such as Te for the purpose of expanding the spectral sensitivity band. ("Photographic Science and Engineering", Vol.26, p. 295, 1982.) Though able to suppress deterioration of sensitivity, the photoconductive layer disclosed in "Photographic Science and Engineering", Vol.26, p. 245, 1982, is not said to be sufficient in the afterimage characteristics of the photoconductivity.

Further, there has been known an addition of a V group element such as As for the purpose of preventing crystallization or improving electron transfer. ("Preparation and Transport Properties of Vacuum Evaporated Selenium Films", Journal of Vacuum Science and Technology, Vol.9, pp. 387-390, 1972. ) Further, in U.S. Patent No. 6,642,534, an impurity in selenium is disclosed.

Since in the amorphous selenium doped with alkaline metal such as disclosed in U.S. Patent Application Publication No. 20030223534, local crystallization occurs, image defect due to lapse of time is apt to occur when the amorphous selenium doped with alkaline metal is used in the photoconductive layer.

### SUMMARY OF THE INVENTION

In view of the foregoing observations and description, the primary object of the present invention is to provide a photoconductive layer which is less in sensitivity deterioration and is improved in the afterimage characteristics of the photoconductivity, and a radiation image taking panel provided with such a photoconductive layer.

Another object of the present invention is to provide a photoconductive layer in which the problem of crystallization is overcome, whereby electron transit is improved and the image defect due to lapse of time can be suppressed, and a radiation image taking panel provided with such a photoconductive layer.

The former object of the present invention can be accomplished by a first photoconductive layer forming a radiation image taking panel characterized by formed by selenium alloy containing therein 0.1 to 1000 molar ppm of monovalent metal and 0.1 to 1000 molar ppm of a chalcogenide element other than Se.

"Monovalent metal" means alkaline metal (Li, Na, K, Rb, Cs), Tl, Ag, Cu or the like, and "chalcogenide element other than Se" means S or Te.

It is preferred that the monovalent metal be Na and the selenium alloy contains therein 0.2 to 200 molar ppm of Na. It is preferred that the chalcogenide element be Te and the selenium alloy contains therein 0.1 to 400 molar ppm of Te.

In accordance with the present invention, there is provided a first radiation image taking panel characterized by comprising a first photoconductive layer formed by selenium alloy containing therein 0.1 to 1000 molar ppm of monovalent metal and 0.1 to 1000 molar ppm of chalcogenide element other than Se.

Contents of monovalent metal in the photoconductive layer is lower than the raw material used by about two digits, and contents of the chalcogenide element in the photoconductive layer is lower than the material used by about 20% to one digit due to distillation effect when it is about 1000 molar ppm. Accordingly, in the product state, the photoconductive layer of the present invention comprises selenium alloy containing therein 0.001 to 10 molar ppm of the monovalent metal and 0.1 to 1000 molar ppm of a chalcogenide element other than Se.

The latter object of the present invention can be accomplished by a second photoconductive layer forming a radiation image taking panel characterized by comprising selenium alloy containing therein 0.1 to 1000 molar ppm of monovalent metal and 0.1 to 4000 molar ppm of a V group element.

"Monovalent metal" means alkaline metal (Li, Na, K, Rb, Cs), Tl, Ag, Cu or the like, and "V group element" means N, P, As, Sb or Bi. "Selenium alloy" means an alloy of selenium and (an) element(s) other than selenium.

It is preferred that the monovalent metal be Na and the selenium alloy contains therein 0.2 to 300 molar ppm of Na. It is preferred that the V group element be Sb and the selenium alloy contains therein 0.15 to 20 molar ppm of Sb. Otherwise it is preferred that the V group element be As and the selenium alloy contains therein 1.5 to 4000 molar ppm of As.

In accordance with the present invention, there is provided a second radiation image taking panel characterized by comprising a second photoconductive layer formed by selenium alloy containing therein 0.1 to 1000 molar ppm of monovalent metal and 0.1 to 4000 molar ppm of V group element.

Contents of monovalent metal in the product is lower than the raw material used by about two figures, and contents of the V group element in the product is lower than the material used by about a half to one figure due to distillation effect when it is about 1000 molar ppm. Accordingly, in the product state, the photoconductive layer of the present invention comprises selenium alloy containing therein 0.001 to 10 molar ppm of the monovalent metal and 0.1 to 2000 molar ppm of a V group element other than Se.

The first photoconductive layer of the present invention is less in sensitivity deterioration and is improved in attenuation speed of x-ray photoelectric current since it comprises selenium alloy containing therein 0.1 to 1000 molar ppm of monovalent metal and 0.1 to 1000 molar ppm of a chalcogenide element other than Se, whereby the time interval at which the image is formed can be shortened and the throughput can be increased. Accordingly, the first photoconductive layer of the present invention is excellent in animation and is better in the afterimage characteristics of the photoconductivity.

Especially, when the monovalent metal is Na while the selenium alloy contains therein 0.2 to 200 molar ppm of Na and the chalcogenide element is Te while the selenium alloy contains therein 0.1 to 400 molar ppm of Te, the first photoconductive layer is further better in the afterimage characteristics of the photoconductivity.

In the second photoconductive layer of the present invention, local crystallization is less apt to occur, whereby electron transit is improved and increase in the image defect in response to progress of the local crystallization with time can be suppressed.

Especially, when the monovalent metal is Na while the selenium alloy contains therein 0.2 to 300 molar ppm of Na and the V group element is Sb while the selenium alloy contains therein 0.15 to 20 molar ppm of Sb or the V group element is As while the selenium alloy contains therein 1.5 to 4000 molar ppm of As, increase in the image defect in response to progress of the local crystallization with time can be suppressed.

### BRIEF DESCRIPTION OF THE DRAWINGS

Figure 1 is a cross-sectional view showing an example of the radiation image taking panel employing the photoconductive layer of the present invention,
Figure 2 is a schematic view showing a recoding/read-out system employing the radiation image taking panel,
Figures 3A to 3D are views showing the latent image forming procedure in an electric charge model,
Figures 4A to 4D are views showing the latent image reading procedure by the recoding/read-out system in an electric charge model,
Figure 5 is a schematic view showing the state where the radiation sensor is integrated with the AMA board,
Figure 6 is a circuit diagram showing an equivalent circuit of the AMA board, and
Figure 7 is a schematic cross-sectional view showing pixels of the radiation detecting portion.

### DESCRIPTION OF THE PREFERRED EMBODIMENT

The first photoconductive layer of the present invention is characterized by comprising selenium alloy containing therein 0.1 to 1000 molar ppm of monovalent metal and 0.1 to 1000 molar ppm of a chalcogenide element other than Se. When the monovalent metal is less than 0.1 molar ppm or when the chalcogenide element other than Se is less than 0.1 molar ppm, deterioration in sensitivity cannot be suppressed and the afterimage characteristics of the photoconductivity cannot be sufficient. When the monovalent metal is more than 1000 molar ppm, crystallization becomes apt to occur and/or the dark current increases. When the chalcogenide element other than Se is more than 1000 molar ppm, it becomes difficult to reproducibly form a photoconductive layer due to fractional distillation and the like.

In order to form film containing therein monovalent metal and a chalcogenide element other than Se, for instance, selenium alloy with which the monovalent metal and the chalcogenide element other than Se have been caused to react may be deposited on a board by a known deposition apparatus.

The second photoconductive layer of the present invention is characterized by comprising selenium alloy containing therein 0.1 to 1000 molar ppm of monovalent metal and 0.1 to 4000 molar ppm of a V group element. When the monovalent metal is less than 0.1 molar ppm or when the V group element is less than 0.1 molar ppm, crystallization cannot be sufficiently suppressed. When the monovalent metal is not less than 1000 molar ppm, crystallization becomes apt to occur and/or the dark current increases even if V group element is contained. When the V group element is not less than 4000 molar ppm, it becomes difficult to reproducibly form a photoconductive layer due to fractional distillation and the like.

In order to form film containing therein monovalent metal and a V group element, for instance, selenium alloy with which the monovalent metal and the V group element have been caused to react may be deposited on a board by a known deposition apparatus.

In the radiation image taking panel, there are a direct conversion system and an indirect conversion system. The first and second photoconductive layer of the present invention may be applied to both the direct conversion system and an indirect conversion system. In the direct conversion system, radiation is directly converted to an electric charge, and the electric charge is stored, and in the indirect conversion system, radiation is once converted to light by a scintillator such as of CsI:Tl or Gd₂O₂S:Tb, and the light is converted to an electric charge by α-Si photodiode, and the electric charge is stored. The radiation may be, for instance, ν-rays and α-rays as well as the x-rays.

The first and second photoconductive layer of the present invention may be applied to both a so-called optical read-out system where the image is read out by a radiation image sensor which is formed on the basis of a semiconductor material and generates an electric charge in response to projection of radiation, and a read-out system where the electric charges generated in response to projection of radiation are stored and the stored electric charges are read out by turning on and off an electrical switch such as a TFT transistor (thin film transistor) by one pixel by one pixel. The latter system will be referred to as "the TFT system", hereinbelow.

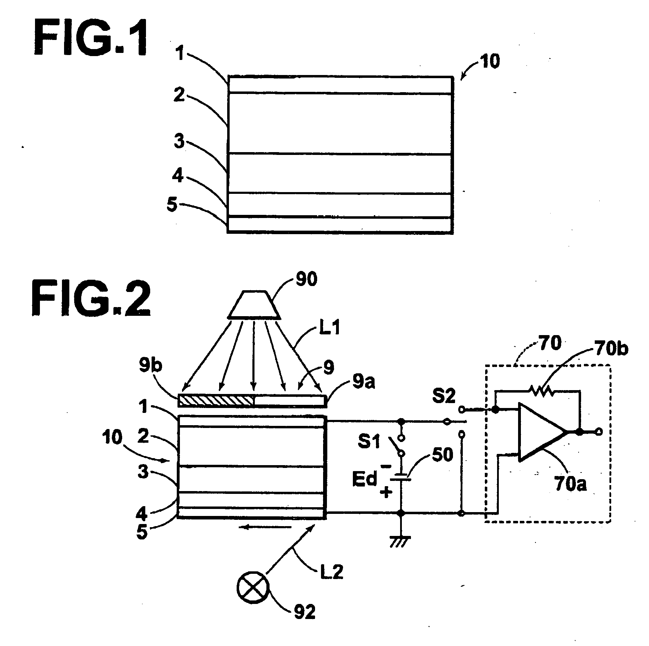

Description will be made first with reference to Figure 1, which is a cross-sectional view of a radiation image taking panel of an optical read-out system to which the first and second photoconductive layer of the present invention are applied.

The radiation image taking panel 10 comprises a first conductive layer 1 which is permeable to recording radiation L1 to be described later, a recording radiation conductive layer 2 which exhibits conductivity upon exposure to the recording radiation L1 passing through the first conductive layer 1, a charge transfer layer 3 which behaves substantially as an insulating material to the electric charge in which the first conductive layer 1 is charged (latent image charge; e.g., a negative charge) and substantially as a conductive material to the electric charge of a polarity opposite to the polarity of the latent image charge (transfer charge; e.g., a positive charge), a read-out light conductive layer 4 which exhibits conductivity upon exposure to the read-out light L2 to be described later, and a second conductive layer 5 which is permeable to the electromagnetic wave L2.
An electron injection blocking layer may be provided between the first conductive layer 1 and the recording radiation conductive layer 2. As the electron injection blocking layer, antimony sulfide or N,N'-diphenyl-N,N'-bis(3-methylphenyl)-(1,1'-biphenyl]-4,4 -diamine (TPD) is employed. A hole injection blocking layer may be provided between the second conductive layer 5 and the read-out light conductive layer 4. As the hole injection blocking layer, ceric oxide, antimony sulfide or zinc sulfide is employed.

As the first and second conductive layers 1 and 5, those comprising conductive material uniformly applied to a transparent glass plate (e.g., nesa film) are preferred. More specifically, those comprising polycrystalline ITO (In₂O₃:Sn), amorphous ITO (In₂O₃:Sn), amorphous IZO (In₂O₂:Zn), ATO (SnO₂:Sb), FTO (SnO₂:F), AZO (ZnO:Al), GZO (ZnO:Ga), film of gold, silver, platinum, aluminum, indium and the like, and applied film of dispersion of precious metal (platinum, gold, silver) of 10 to 1000nm are preferred.

The more the difference between the mobility of the negative charge in the first conductive layer 1 and the mobility of the positive charge opposite to the polarity of the first conductive layer 1 is, the charge transfer layer 3 is the better, and as the charge transfer layer 3, an organic compound; such as polyN-vinyl carbazole (PVK), N,N'-diphenyl-N,N' -bis (3-methylphenyl)-[1,1'-biphenyl]-4,4-diam ine (TPD) or a discotheque liquid crystal; a polymer <polycarbonate, polystyrene, PVK, polyvinyl alcohol> dispersion of TPD; As₂Se₃; Sb₂S₃; silicone oil; a semiconductor material such as a-Se doped with 10 to 200ppm of Cl; polycarbonate; and the like are suitable. Especially, an organic compound (PVK, TPD, a discotheque liquid crystal or the like) is preferred since having an insensitivity to light, and at the same time, the charge transfer layer 3 and the read-out light conductive layer 4 can be small in capacity since the organic compound is generally small in dielectric constant, whereby signal taking out efficiency when the image is to be read out can be increased.

As the read-out light conductive layer 4, photoconductive material containing therein at least one of the following material as a main component is suitable. That is, a-Se, a-Se doped with 10 to 200ppm of Cl, a-Se doped with 5 to 200ppm of As, Se-Te, Se-As-Te, As₂Se₃, metal-free phthalocyanine, metallic phthalocyanine, MgPc (Magnesium phthalocyanine), VoPc (Phase II of Vanadyl phthalocyanine), CuPc (Cupper phthalocyanine), Bi₁₂MO₂₀ (M:Ti, Si, Ge), BiM₃O₁₂ (M:Ti, Si, Ge), Bi₂O₃, BiMO₄ (M:Nb, Ta, V), Bi₂₄B₂O₃₉, ZnO, ZnS, ZnSe, ZnTe, MNbO₃ (M:Li, Na, K), PbO, HgI₂, PbI₂, cdS, CdSe, CdTe, BiI₃ and the like. Further, selenium alloy containing therein 0.1 to 1000 molar ppm of monovalent metal and 0.1 to 4000 molar ppm of V group element can be suitably used.

As the recording radiation conductive layer 2, the photoconductive layers of the present invention are used. That is, the photoconductive layers of the present invention are a recording radiation conductive layer. In the case of the first photoconductive layer of the present invention, it is preferred that the monovalent metal be added in the form of a chalcogenide compound. When the monovalent metal is Na, Na is added in the form of Na₂Se, Na₂S and Na₂Te. Na may be added in the form of Na₂SeO₃, NaOH and NaCl. It is preferred that each of S and Te be added as a simplex. In the case of the second photoconductive layer of the present invention, it is preferred that the monovalent metal be added in the form of a chalcogenide compound. When the monovalent metal is Na, Na is preferably added in the form of Na₂Se, though it may be added in the form of Na₂S and Na₂Te. Though it is preferred that As be added in the form of As₂Se₃ or simplex, selenium doped with As, Sb be added in the form of Sb₂Se₃ or simplex, and Bi be added in the form of Bi₂Se₃ or simplex, they may be added in the form of sulfide or telluride.

A system where light is used in order to read out an electrostatic latent image will be described in brief, hereinbelow. Figure 2 shows a recoding/read-out system (wherein an electrostatic latent image recording system and an electrostatic latent image read-out system are integrated) employing the radiation image taking panel 10. The recording/read-out system comprises the radiation image taking panel 10, a recording radiation projecting means 90, a power source 50, an electric current detecting means 70, a read-out exposure means 92, and a pair of connecting means S1 and S2. The electrostatic latent image recording portion comprises the radiation image taking panel 10, the power source 50, the recording radiation projecting means 90, and the connecting means S1 and the electrostatic latent image read-out portion comprises the radiation image taking panel 10, the electric current detecting means 70 and the connecting means S2.

The first conductive layer 1 of the radiation image taking panel 10 is connected to the negative pole of the power source 50 by way of a connecting means S1 and is connected to one end of the connecting means S2. The other end of the connecting means S2 is movable among a first position where it is connected neither the electric current detecting means 70 nor the ground but is opened, a second position where it is connected to the electric current detecting means 70, and a third position where it is grounded. The second conductive layer 5 of the radiation image taking panel 10 and the positive pole of the power source 50 are grounded. The electric current detecting means 70 comprises a detecting amplifier 70a (operational amplifier) and a feedback resistor 70b, and forms a so-called current-voltage conversion circuit.

The second conductive layer 5 may be of a structure disclosed in, for instance, Japanese Unexamined Patent Publication Nos. 2001-337171 and 2001-160922.

On an upper surface of the first conductive layer 1, an object 9 is disposed, and the object 9 has a permeable part 9a permeable to the radiation L1 and a radiation cut part 9b impermeable to the radiation L1. The recording radiation projecting means 90 projects the radiation L1 uniformly onto the object 9, while the read-out exposure means 92 scans the read-out light L2 such as a laser beam or light emitted from an LED, organic EL or an inorganic EL in the direction shown by the arrow in Figure 2. The read-out light L2 is preferred to have a lineally converged shape.

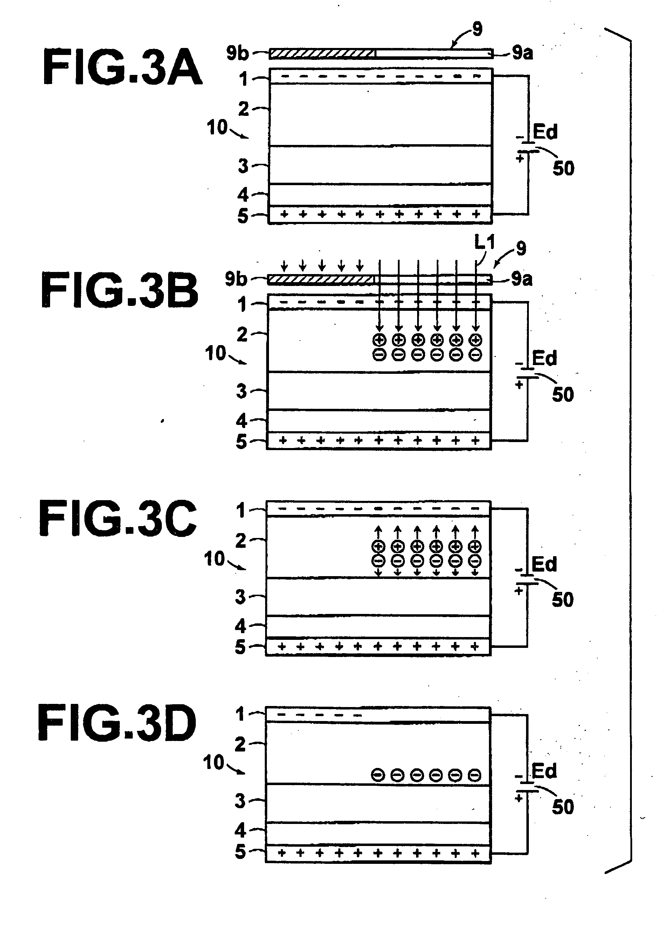

Electrostatic latent image forming procedure in the recording/read-out system will be described referring to an electric charge model shown in Figures 3A to 3D. When said the other end of the connecting means S2 is brought to the first position where the connecting means S2 is disconnected from the ground and the electric current detecting means 70 and is opened and the connecting means S1 is turned on, a DC voltage Ed is imparted between the first and second conductive layers 1 and 5 by the power source 50, and the first conductive layer 1 is charged in a negative electric charge while the second conductive layer 5 is charged in a positive electric charge (Figure 3A), whereby a parallel electric field is established between the first and second conductive layers 1 and 5 of the radiation image taking panel 10.

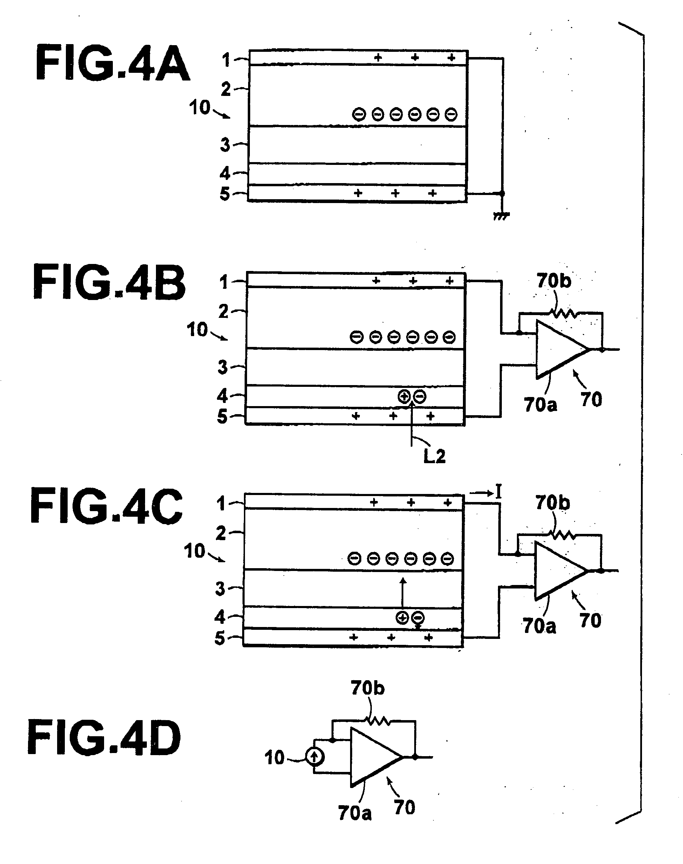

Then the radiation L1 is uniformly projected toward the object 9 from the recording radiation projecting means 90. The radiation L1 passes through the permeable part 9a of the object 9 and the first conductive layer 1. Upon exposure to the passing-through radiation L1, the recording radiation conductive layer 2 comes to exhibit conductivity. This can be understood as the recording radiation conductive layer 2 acts as a variable resistor whose resistance is variable according to the amount of radiation and since resistance depends upon that charged pairs comprising electrons (negative charges) and holes (positive charges) are generated by the radiation L1, the recording radiation conductive layer 2 exhibits a larger resistance as the amount of the radiation L1 passing through the object 9 reduces. (Figure 3B) The negative charges and the positive charges generated by the radiation L1 are expressed in Figures 3A to 3D and Figures 4A to 4D by circumscribing - or + with a circle.

The positive charges generated in the recording radiation conductive layer 2 move toward the first conductive layer 1 at a high speed in the recording radiation conductive layer 2 and recombine with negative charges in which the first conductive layer 1 is charged to vanish. (Figures 3C and 3D) The negative charges generated in the recording radiation conductive layer 2 move toward the charge transfer layer 3 in the recording radiation conductive layer 2. Since the charge transfer layer 3 behaves substantially as an insulating material to the electric charge in the same polarity as that in which the first conductive layer 1 is charged (in this particular embodiment, a negative charge), the negative charges moving in the recording radiation conductive layer 2 are stopped at the interface between the recording radiation conductive layer 2 and the charge transfer layer 3, and collected thereon. (Figures 3C and 3D) The amount of the electric charge collected is governed by the amount of negative charges generated in the recording radiation conductive layer 2, that is, the amount of the radiation L1 passing through the object 9.

Since the radiation L1 does not pass through the radiation cut part 9b of the object 9, the part of the radiation image taking panel 10 under the cut part 9b is held unchanged. (Figures 3B to 3D) By thus exposing the object 9 to the radiation L1, an electric charge according to an image of the object 9 can be collected on the interface between the recording radiation conductive layer 2 and the charge transfer layer 3. The image of the object 9 represented by the collected charges is referred to as "the electrostatic latent image".

The electrostatic latent image read-out procedure will be described referring to an electric charge model shown in Figures 4A to 4D. The connecting means S1 is opened, and the Connecting means S2 is once grounded to rearrange the electric charge by charging the first and second conductive layers 1 and 5 of the radiation image taking panel 10 in the same potential as shown in Figure 4A and then connected to the current detecting means 70.

Then, when the read-out light L2 is caused to scan the second conductive layer 5 of the radiation image taking panel 10 by the read-out exposure means 92, the read-out light L2 passes the second conductive layer 5 to impinge upon the read-out light photoconductive layer 4 and the read-out light photoconductive layer 4 exposed to the read-out light L2 comes to exhibit conductivity upon exposure to the read-out light L2. This depends upon that negative charges and positive charges are generated in the read-out light photoconductive layer 4 in response to exposure to the read-out light L2 similarly to that the radiation photoconductive layer 2 exhibits conductivity due to generation of negative charges and positive charges in response to exposure to the radiation L1. (Figure 4B) similarly to the recording procedure, the negative charges and the positive charges generated by the read-out light L2 are expressed in Figures 3A to 3D and Figures 4A to 4D by circumscribing - or + with a circle.

Since the charge transfer layer 3 behaves as a conductive body to positive charges, the positive charges generated in the photoconductive layer 4 are rapidly moved through the charge transfer layer 3 as if they are attracted by the collected charges and recombine with the collected charges at an interface between the radiation photoconductive layer 2 and the charge transfer layer 3 to vanish. (Figure 4C) The negative charges generated in the photoconductive layer 4 recombine with the positive charges on the second conductive layer 5 to vanish. (Figure 4C) The photoconductive layer 4 is scanned by the read-out light L2 with a sufficient amount of light. Accordingly, the collected charges collected on the interface between the radiation conductive layer 2 and the charge transfer layer 3, i.e., the electrostatic latent image, are all vanish through the charge recombination. That the charges collected in the radiation image taking panel 10 vanish means that a current I flows in the radiation image taking panel 10 due to movement of the electric charges, and this state can be shown by the equivalent circuit such as shown in Figure 4D where the radiation image taking panel 10 is expressed by a current source the amount of current of which depends upon the amount of collected charges.

By detecting the electric current flowing out the radiation image taking panel 10 while scanning the read-out light L2, the amount of charges collected on each part (corresponding to a pixel) can be read out in sequence, whereby an electrostatic latent image can be read out. The action of the read-out portion is disclosed in Japanese Unexamined Patent Publication No. 2000-105297 and the like.

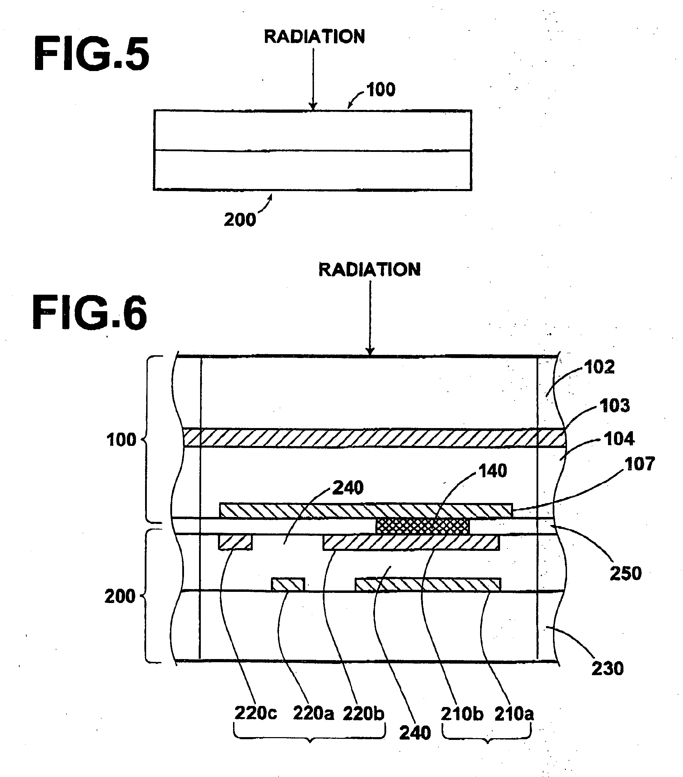

A radiation image taking panel of the TFT system will be described, hereinbelow. The radiation image taking panel comprises a radiation detecting portion 100 and an active matrix array board (will be referred to as "AMA board", hereinbelow) 200 bonded to each other as shown in Figure 5. As shown in Figure 6, the radiation detecting portion 100 broadly comprises a common electrode 103 for imparting a bias voltage, a photoconductive layer 104 which generates carriers, each of which is an electron-hole pair, sensing object radiation to be detected, and a detecting electrode 107 for collecting carriers superposed in this order from the side from which the radiation impinges upon the radiation image taking panel. A radiation detecting portion support may be provided in the layers above the common electrode 103.

The photoconductive layer 104 may comprise a first or second photoconductive layer of the present invention. Whereas the common electrode 103 or the detecting electrode 107 comprises conductive material such as an ITO (indium-tin oxide), Au or Pt. According to the polarity of the bias voltage, a hole injection blocking layer or an electron injection blocking layer may be provided in addition to the common electrode 103 or the detecting electrode 107. As the hole injection blocking layer, ceric oxide, antimony sulfide or zinc sulfide is employed. As the electron injection blocking layer, antimony sulfide or N,N'-diphenyl-N,N'-bis(3-methylphenyl)-[1,1'-biphenyl]-4,4 -diamine (TPD) is employed. The electrostatic latent image read-out portion.

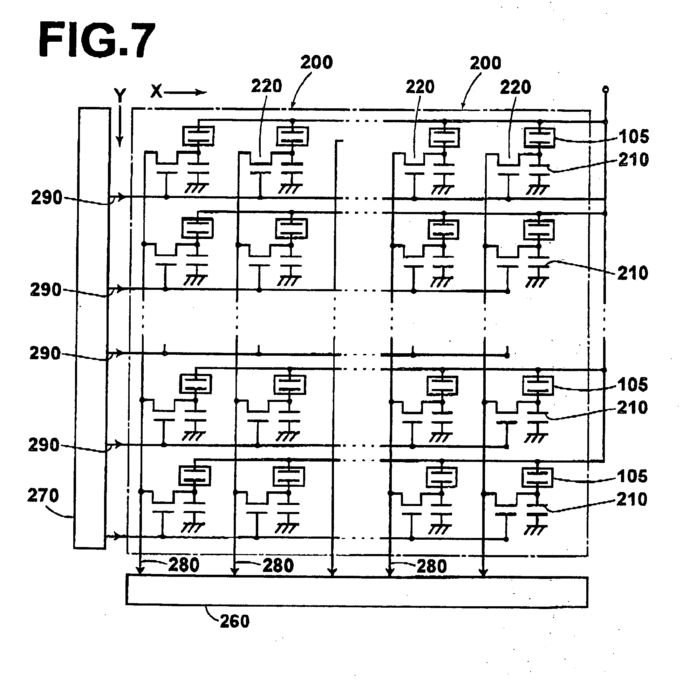

Structure of the AMA board 200 will be briefly described, hereinbelow. As shown in Figure 7, in the AMA board 200, a capacitor 210 and a TFT 220 are provided one for each of the radiation detecting portion 105 corresponding to a pixel. Each of the capacitor 210 has a capacitance which conform to the collected electric charges and the TFT 220 is as a switching element. In the support 102, the radiation detecting portions 105, each corresponding to a pixel, are two-dimensionally arranged in a matrix (e.g., vertically 1000 to 3000 and horizontally 1000 to 3000 according to the necessary number of the pixels) and in the AMA board 200, the capacitors 210 and the TFTs 220 the same in number as the pixels are two-dimensionally arranged in the same matrix. The electric charges generated in the photoconductive layer is collected in the capacitors 210 and form a latent image. In the TFT system, the latent image generated by the radiation is held by the capacitors 210.

The capacitor 210 and the TFT 220 are as shown in Figure 6 in specific structure in the AMA board 200. That is, an AMA board base 230 is an insulator and the connecting electrode 210b of the capacitor 210 and the source electrode 220b and the drain electrode 220c of the TFT 220 are laminated over the ground electrode 210a of the capacitor 210 and the gate electrode 220a of the TFT 220 formed on the surface thereof by way of an insulating film 240 with the surface of the capacitors 210 and the TFT 220 covered with a protective insulating film 250. Further, the connecting electrode 210b of the capacitor 210 and the source electrode 220b of the TFT 220 are integrated into one electrode and formed simultaneously. As the insulating film 240 forming both the capacity insulating film of the capacitor 210 and the insulating film for the gate of the TFT 220, for instance, plasma SiN film is employed. The AMA board 200 is produced by the use of a film forming technic and/or fine processing technic such as used for producing a substrate for a liquid crystal display.

Bonding of the radiation detecting portion 100 and the AMA board 200 will be described, hereinbelow. With the detecting electrode 107 located with respect to the connecting electrode 210b of the capacitor 210, the boards 100 and 200 are heat-bonded with anisotropic conductive film (ACF), which includes therein conductive particles such as silver particles and has a conductivity only in the direction of thickness, intervening therebetween, whereby the boards 100 and 200 are mechanically integrated and the detecting electrode 107 and the connecting electrode 210b are electrically connected by way of the intervening conductive portion 140.

The AMA board 200 is provided with a read-out drive circuit 260 and a gate drive circuit 270. As shown in Figure 7, the read-out drive circuit 260 is connected to a vertical (Y direction) read-out wiring (read-out address wiring) 280 which connects the drain electrodes of the TFTs 220 which are on the same column and the gate drive circuit 270 is connected to a horizontal (X direction) read-out wiring (gate address wiring) 290 which connects the gate electrodes of the TFTs 220 which are on the same row. Though not shown, pre-amplifiers (charge-voltage converter) are connected to the wirings 280, each to one wiring 280, in the read-out drive circuit 260. The read-out drive circuit 260 and the gate drive circuit 270 are thus connected to the AMA board 200, though those where the read-out drive circuit 260 and the gate drive circuit 270 are molded in one-piece with the AMA board 200, thereby intending to an integration, are employed.

The radiation image taking system where the radiation detecting portion 100 and the AMA board 200 are bonded together is disclosed, for instance, in Japanese Unexamined Patent Publication No. 11(1999)-287862.

Embodiments of the first photoconductive layer of the present invention are shown, hereinbelow.

### (Embodiments 1 to 12, comparative examples 2 to 6)

High-purity selenium (6NSuper:Ohsaka Asahi Metal) were added with Na2Se for doping Na, and amorphous tellurium for doping Te, filled in a quartz tube, vacuumed, sealed and caused to react at 500 °C to make selenium alloys shown in Table 1. The selenium alloys were filled in a stainless crucible and a deposited Se film containing therein Na and Te were formed in thickness of 200µm on an amorphous IZO glass substrate under conditions of a crucible temperature of 300°C, a degree of vacuum of 0.0001Pa, a substrate temperature of 65°C, and a deposition rate of 1µm/min. By the use of the Se film thus made, devices with an upper electrode of gold were produced in thickness of 100nm by the deposition.

### (Embodiments 13 to 17, a comparative example 7)

Devices were produced using the selenium alloys having compositions shown in Table 1 in the same manner as the embodiment 1 except that the amorphous tellurium was replaced with amorphous sulfur.

### (A comparative example 1)

A device was produced in the same manner as the embodiment 1 except that the high-purity selenium was doped with no Na nor Te.

### (Measurement of Lag after image)

1R of X-rays were projected for two seconds onto a sample under the condition of 30kV (electric voltage) with an MO tube, the generated pulse-like photocurrent were converted to a voltage by a current amplifier under the same conditions as the conditions under which the voltage was imparted, and the x-ray photocurrent signal was measured with a digital oscilloscope. The imparted voltage was equivalent to an electric field of 10V/µm. By measuring the obtained current-time for thirty seconds, the Lag was expressed in the absolute value of a common logarithm of the ratio of the intensity of the photocurrent fifteen seconds after end of the x-ray projection to a maximum photocurrent during the x-ray projection. The larger the absolute value is, the more excellent afterimage characteristics is.

### (Analysis of the raw material employed in the device)

Analysis of the raw material was carried out by a glow-discharge mass spectrometry (GDMS). The element concentration in selenium is in ppm representing the molar fraction per one molar of selenium. The 6N super selenium of the comparative example was smaller than limit of measurement in the element concentration and the Na concentration, S concentration and the Te concentration was smaller than 0.03 molar ppm, 0.01 molar ppm and 0.03 molar ppm, respectively.

Results are shown in the following Table 1.

**Table 1**

| | raw material | | Lag |
|---|---|---|---|
| | Na | Te | |
| embodiment 1 | 0.2 | 2.5 | 3.1 |
| embodiment 2 | 3 | 0.1 | 3.5 |
| embodiment 3 | 2.9 | 2.3 | 3.4 |
| embodiment 4 | 3.1 | 6.2 | 3.5 |
| embodiment 5 | 3.3 | 31 | 3.4 |
| embodiment 6 | 35 | 31 | 3.5 |
| embodiment 7 | 370 | 2.4 | 3.1 |
| embodiment 8 | 377 | 32 | 3.0 |
| embodiment 9 | 368 | 310 | 2.9 |
| embodiment 10 | 34 | 3.1 | 3.3 |
| embodiment 11 | 34 | 322 | 3.0 |
| embodiment 12 | 187 | 2.5 | 3.3 |
| Comparative example 1 | high-purity selenium | | 2.2 |
| comparative example 2 | 0.05 | 2.5 | 2.2 |
| comparative example 3 | 3.2 | 0.04 | 2.3 |
| comparative example 4 | 1150 | 1240 | 2.0 |
| comparative example 5 | 1100 | 25 | 2.3 |
| comparative example 6 | 379 | 1230 | 1.9 |
| embodiment 13 | 27 | 1.2 | 2.8 |
| embodiment 14 | 27 | 4.9 | 3.0 |
| embodiment 15 | 27 | 2.4 | 3.3 |
| embodiment 16 | 27 | 246 | 3.1 |
| embodiment 17 | 27 | 970 | 2.6 |
| comparative example 7 | 27 | <0.1 | 2.2 |

As can be understood from table 1, each of the devices of the embodiments 1 to 17 is less in sensitivity deterioration and is improved in attenuation speed of x-ray photoelectric current since it is formed by selenium alloy containing therein 0.1 to 1000 molar ppm of monovalent metal and 0.1 to 1000 molar ppm of a chalcogenide element other than Se. Though in the case of a semi-animation of five frames/second or an animation of five to thirty frames/second, there arises a problem that an image becomes unsharp or disturbed when it is affected by a previously sensed electric signal, the first photoconductive layer of the present invention can be less apt to be affected by a previously sensed electric signal even if it is applied to an animation needless to say applied to a semi-animation since it is excellent in afterimage characteristics.

In the comparative example 1, where no monovalent metal and chalcogenide element other than Se is doped, and the comparative examples 2, 3 and 7 where though doped with a monovalent metal and a chalcogenide element other than Se, the amounts of them is poor, improvement in attenuation speed of x-ray photoelectric current is not sufficient. In the embodiments 7 to 9 and 11, where though doped with a monovalent metal and a chalcogenide element other than Se, the amounts of them is about to be too large, there is a tendency that attenuation speed of x-ray photoelectric current becomes worse. In the comparative examples 4 to 6 and 11, where though doped with a monovalent metal and a chalcogenide element other than Se, the amounts of them is too large, attenuation speed of x-ray photoelectric current becomes markedly worse.

In the embodiments 1 to 6 and 10 to 17, where the Na contents of the Se alloy raw material is between 0.2 to 200 molar ppm, the afterimage characteristics of the photoconductivity can be more improved.

### (Analysis of the deposited film in the device)

In order to measure the element concentration in the deposited film of the devices of the comparative example 1 and the embodiment 4, a silicone wafer was prepared together with a 5cm square glass substrate on which an amorphous IZO layer and a comb electrode were provided and depositions were carried out simultaneously under the conditions of the comparative example 1 and the embodiment 4. The whole amount of selenium alloy film on the silicone substrate was dissolved in nitric acid and the amount of the selenium in the solution is quantified by ICP luminescence while the amounts of Na and Te in the solution were respectively quantified by absorption spectrometry of an atom of a graphite type and ICP-MS. The concentration of each atom with respect to the selenium was obtained. At this time, in order to remove the influence of the surface Na contamination, washing with water was carried out twice to remove Na, K or the like which was not incorporated in the selenium layer, and in the ICP analysis, etching not larger than 0.1nm, where almost no selenium was detected, was carried out twice. In the case where an inorganic layer or an organic layer other than selenium was provided on the selenium layer, the selenium layer adhering to the substrate or standing alone could be obtained by peeling-off due to strain stress generated by change in volume by crystallizing the selenium layer or due to expansion difference generated by quenching the selenium layer.

The amounts of Na and Te in the device of the comparative example 1 were respectively smaller than 0.001 molar ppm and smaller than 0.07 molar ppm, and were smaller than the limit of detection. Whereas, the amounts of Na and Te in the device of the embodiments 4 were 0.01 molar ppm and 3 molar ppm, respectively. This fact shows that Na is hard to be incorporated in selenium upon deposition and the concentration of Te in the deposited film tends to be slightly smaller than the concentration of Te in the raw material.

As can be understood from the description above, the first photoconductive layer of the present invention is improved in attenuation speed of x-ray photoelectric current since it comprises selenium alloy containing therein 0.1 to 1000 molar ppm of monovalent metal and 0.1 to 1000 molar ppm of a chalcogenide element other than Se, whereby since animation characteristics can be excellent and the time interval at which the image is formed can be shortened, the throughput can be increased and the afterimage characteristics of the photoconductivity can be improved.

Embodiments of the second photoconductive layer of the present invention are shown, hereinbelow.

### (Embodiments 1 to 10, comparative examples 2 to 6)

A comb electrode was formed on a 5cm square glass substrate on which an amorphous IZO layer had been provided and high-purity selenium (6NSuper:Ohsaka Asahi Metal) was deposited into Se film 10µ thick under conditions of a crucible temperature of 300°C, a degree of vacuum of 0.0001Pa, a substrate temperature of 65°C, and a deposition rate of 1µm/min by the use of a vacuum metallizer. Further, As₂Se₃ (6N:Huruuchi Kagaku) is laminated thereon in thickness of 0.2µm at a crucible temperature of 460°C. Further, high-purity selenium were added with Sb₂Se₃ and Na₂Se, filled in a quartz tube, vacuumed, sealed and caused to react at 550°C to make Se alloys shown in Table 2. The selenium alloy was deposited under condition of a deposition rate of 1µm/min into a deposited film 200µm thick with the board temperature changed to 55°C. Devices with an upper electrode of gold were produced in thickness of 600nm by sputtering.

### (Embodiments 11 to 20, a comparative example 7 to 11)

Devices were produced using the selenium alloys having compositions shown in Table 2 in the same manner as the embodiment 1 except that Sb₂Se₃ was replaced with As₂Se₃.

### (A comparative example 1)

A device was produced in the same manner as the embodiment 1 except that the high-purity selenium was doped with no Na nor Te.

### (Amount of the collected electric charge and image defect)

Amount of the collected electric charge was measured employing an image read-out system disclosed in Japanese Unexamined Patent Publication No. 2004-147255. The image defect was measured in the following way. That is, the signal was output as a two-dimensional image with no radiation and light projected onto the object by the use of the same read-out system and spots not smaller than 10µm were counted, while spots were counted in the same manner after subsequently two weeks lapse dry at 40°C, whereby the ratio in image defect between before and after the time lapses was calculated.

### (Analysis of the raw material employed in the device)

Analysis of the raw material was carried out by a glow-discharge mass spectrometry (GDMS). The element concentration in selenium is in ppm representing the molar fraction per one molar of selenium. The 6N super selenium of the comparative example 1 was smaller than limit of measurement in the element concentration and the Na concentration, S concentration and the Te concentration was smaller than 0.03 molar ppm, 0.06 molar ppm and 1 molar ppm, respectively.

Results are shown in the following Table 2. The amount of the collected electric charge and the ratio in image defect are both shown as a relative value to that of the comparative example.

**Table 2**

| | raw material | | amount of collected electric charge | image defect ratio |
|---|---|---|---|---|
| | Na | Sb | | |
| embodiment 1 | 0.2 | 0.19 | 1.5 | 1 |
| embodiment 2 | 2.7 | 0.69 | 1.7 | 1.1 |
| embodiment 3 | 30 | 0.67 | 2 | 1.2 |
| embodiment 4 | 151 | 0.65 | 1.9 | 1.3 |
| embodiment 5 | 31 | 0.64 | 1.8 | 1.2 |
| embodiment 6 | 34 | 6.5 | 1.8 | 1.1 |
| embodiment 7 | 343 | 0.19 | 1.7 | 1.5 |
| embodiment 8 | 148 | 65 | 1.8 | 1.2 |
| embodiment 9 | 343 | 27 | 1.3 | 2 |
| embodiment 10 | 34 | 19 | 1.5 | 1.1 |
| comparative example 1 | high-purity selenium | | 1 | 1 |
| comparative example 2 | 0.06 | 0.21 | 1.1 | 1 |
| comparative example 3 | 3 | <0.006 | 1.7 | 7.9 |
| comparative example 4 | 29 | <0.006 | 1.8 | 10.9 |
| comparative example 5 | 1030 | 6.5 | 1.6 | 5.2 |
| comparative example 6 | 1030 | 27 | 1.1 | 4.1 |
| embodiment 11 | 35 | 1.3 | 1.7 | 1.5 |
| embodiment 12 | 34 | 5 | 1.8 | 1.3 |
| embodiment 13 | 36 | 15 | 1.8 | 1.2 |
| embodiment 14 | 34 | 53 | 1.8 | 1.1 |
| embodiment 15 | 69 | 16 | 1.9 | 1.2 |
| embodiment 16 | 34 | 105 | 1.5 | 1.1 |
| embodiment 17 | 2.9 | 38 | 1.5 | 1.1 |
| embodiment 18 | 33 | 419 | 1.4 | 1 |
| embodiment 19 | 37 | 997 | 1.4 | 1 |
| embodiment 20 | 38 | 3820 | 1.3 | 1 |
| comparative example 7 | 34 | <1 | 1.7 | 7.5 |
| comparative example 8 | 35 | 10120 | 1.1 | 1 |
| comparative example 9 | limit of detection ≤ | 41 | 1.1 | 1 |
| comparative example 10 | limit of detection ≤ | 398 | 0.8 | 1 |
| comparative example 11 | limit of detection ≤ | 4200 | 0.5 | 1 |

As can be understood from table 2, each of the devices of the embodiments 1 to 20 is larger in the amount of collected electric charge and can more suppress increase in the image defect with time as compared with the devices of comparative example 1 in Table 2 which are free from a monovalent metal and a V group element since it is formed by selenium alloy containing therein 0.1 to 1000 molar ppm of monovalent metal and 0.1 to 4000 molar ppm of a V group element as a row material. Further, each of the devices of the embodiments 1 to 17 is larger in the amount of collected electric charge as compared with comparative example 2 whose monovalent metal contents are lower than 0.1 molar PPM and can remarkably suppress increase in the image defect with time as compared with devices of comparative examples 3, 4 and 7 whose V group element contents are smaller than 0.1 molar PPM. From the comparative examples 5 and 6, it is found that when the Na contents are not lower than 1000 molar ppm, increase in the image defect with time cannot be suppressed even if Sb of a V group element is added.

Comparison of the embodiments 7 and 9 reveals that when the V group element contents is too high, the amount of collected electric charge is reduced though can suppress increase in the image defect with time.

Devices formed by selenium alloy containing therein not larger than 4000 molar ppm of As are excellent in the amount of collected electric charges and free from increase in the image defect with time.

### (Analysis of the deposited film in the device)

In order to measure the element concentration in the deposited film of the devices of the comparative example 1 and the embodiment 2, a silicone wafer was prepared together with a 5cm square glass substrate on which an amorphous IZO layer and a comb electrode were provided and depositions were carried out simultaneously under the conditions of the comparative example 1 and the embodiment 6. The whole amount of selenium alloy film on the silicone substrate was dissolved in nitric acid and the amount of the selenium in the solution is quantified by ICP luminescence while the amounts of Sb and As in the solution are respectively quantified by absorption spectrometry of an atom of a graphite type and ICP-MS. The concentration of each atom with respect to the selenium was obtained. At this time, in order to remove the influence of the surface Na contamination, washing with water was carried out twice to remove Na, K or the like which was not incorporated in the selenium layer, and in the ICP analysis, etching not larger than 0.1nm, where almost no selenium was detected, was carried out twice.

In the case where an inorganic layer or an organic layer other than selenium was provided on the selenium layer, the selenium layer adhering to the substrate or standing alone could be obtained by peeling-off due to strain stress generated by change in volume by crystallizing the selenium layer or due to expansion difference generated by quenching the selenium layer.

The amounts of Na and Sb in the device of the comparative example 1 were respectively smaller than 0.02 molar ppm and smaller than 0.07 molar ppm, and were smaller than the limit of detection. Whereas, the amounts of Na and Sb in the device of the embodiment 2 were 0.03 molar ppm and 0.2 molar ppm, respectively. This fact shows that Na is hard to be incorporated in selenium upon deposition and the concentration of Sb in the deposited film tends to be slightly smaller than the concentration of Sb in the raw material. The concentration of Na in the devices of the embodiments 14 and 20 were 0.03 molar ppm and the concentration of As in the devices of the embodiments 14 and 20 were 45 molar ppm and 980 molar ppm, respectively. This fact shows that the concentration in the deposited film tends to be lowered from the concentration in the row material as the As concentration increases.

As can be understood from the description above, in the second photoconductive layer of the present invention, the local crystallization can be prevented and travel of the carrier is improved, whereby increase in the image defect with time can be suppressed since it comprises selenium alloy containing therein 0.1 to 1000 molar ppm of monovalent metal and 0.1 to 4000 molar ppm of a V group element.

## Claims

1. A photoconductive layer (2) forming a radiation image taking panel (10) **characterized** formed by selenium alloy containing therein 0.1 to 1000 molar ppm of monovalent metal and 0.1 to 1000 molar ppm of a chalcogenide element other than Se.

2. A photoconductive layer (2) as defined in Claim 1 in which the monovalent metal is Na and the selenium alloy contains therein 0.2 to 200 molar ppm of Na.

3. A photoconductive layer (2) as defined in Claim 1 or 2 in which the chalcogenide element is Te and the selenium alloy contains therein 0.1 to 400 molar ppm of Te.

4. A photoconductive layer (2) forming a radiation image taking panel (10) comprising the selenium alloy containing therein 0.001 to 10 molar ppm of the monovalent metal and 0.1 to 1000 molar ppm of a chalcogenide element other than Se.

5. A radiation image taking panel (10) **characterized by** comprising a photoconductive layer (2) as defined in any one of Claims 1 to 4.

6. A photoconductive layer (2) forming a radiation image taking panel (10) **characterized by** comprising selenium alloy containing therein 0.1 to 1000 molar ppm of monovalent-metal and 0.1 to 4000 molar ppm of a V group element.

7. A photoconductive layer (2) as defined in Claim 6 in which the monovalent metal is Na and the selenium alloy contains therein 0.2 to 300 molar ppm of Na.

8. A photoconductive layer (2) as defined in Claim 6 in which the V group element is Sb and the selenium alloy contains therein 0.15 to 20 molar ppm of Sb.

9. A photoconductive layer (2) as defined in Claim 6 or 7 in which the V group element is As and the selenium alloy contains therein 1.5 to 4000 molar ppm of As.

10. A photoconductive layer (2) comprising the selenium alloy containing therein 0.001 to 10 molar ppm of monovalent metal and 0.1 to 2000 molar ppm of V group element.

11. A radiation image taking panel **characterized by** comprising a photoconductive layer (2) as defined in any one of Claims 6 to 10.
